Europäisches Patentamt

European Patent Office

Office européen des brevets

(11) Veröffentlichungsnummer: **0 008 807**
**A1**

## (12) EUROPÄISCHE PATENTANMELDUNG

(21) Anmeldenummer: **79103388.9**

(22) Anmeldetag: **11.09.79**

(51) Int. Cl.³: **C 23 C 13/08**

(30) Priorität: **13.09.78 DE 2839747**
**13.09.78 DE 7827143 U**

(43) Veröffentlichungstag der Anmeldung:
**19.03.80 Patentblatt 80/6**

(84) Benannte Vertragsstaaten:
**DE FR GB IT**

(71) Anmelder: **Elektroschmelzwerk Kempten GmbH**
**Herzog-Wilhelm-Strasse 16**
**D-8000 München 2(DE)**

(72) Erfinder: **de Rudnay, André, Dr.**
**16, Chemin de Renens Chateau de Valency**
**CH-1004 Lausanne(CH)**

(54) **Vorrichtung und Verfahren zum diskontinuierlichen oder kontinuierlichen thermischen Bedampfen von Formteilen oder Bandmaterial.**

(57) Gegenstand der Erfindung ist eine Vorrichtung für diskontinuierlich betriebene HV-Aufdampfanlagen zum thermischen Bedampfen von Formteilen aus Kunststoff, Metall oder Glas oder für kontinuierlich betriebene Bandbedampfungsanlagen zum Beschichten von Bandmaterial, wie Kunststoffolien, Papierbahnen oder Textilien, mit beispielsweise Aluminium. Innerhalb des Hauptvakuumbehälters mit den zu bedampfenden Formteilen oder dem Bandmaterial ist ein zweiter Behälter (4) angeordnet, in dem die Verdampfer (1) montiert sind, der unabhängig vom Hauptbehälter vakuumdicht verschliessbar ist (6). Diese Vorrichtung ist für den Einsatz von Verdampfern aus Sinterkeramik besonders geeignet.

./...

EP 0 008 807 A1

Croydon Printing Company Ltd

_Fig. 1_

ELEKTROSCHMELZWERK KEMPTEN

GMBH

München, den 18.7.1979
LC-PAT/Dr.Wg/we

Es 7707
=======

0008807

BEZEICHNUNG GEÄNDERT
siehe Titelseite

## Vorrichtung zum diskontinuierlichen oder kontinuierlichen thermischen Bedampfen von Formteilen oder Bandmaterial.

Für das Aufbringen dünner Schichten auf Oberflächen durch thermisches Bedampfen sind Vakuumaufdampf- bzw. Bedampfungsanlagen bekannt, die in Abhängigkeit von Form und Größe der zu bedampfenden Gegenstände und der Art des jeweils verwendeten Aufdampfmaterials diskontinuierlich oder kontinuierlich betrieben werden können.

Formteile aus Kunststoff, Metall oder Glas werden vorteilhaft in diskontinuierlich betriebenen Hochvakuumaufdampfanlagen der thermischen Bedampfung unterzogen, wobei als Aufdampfmaterial beispielsweise Metalle, wie Aluminium, Gold, Kupfer oder Silber Verwendung finden.

Für den Bedampfungsvorgang selbst sind hierbei hohe Betriebstemperaturen notwendig, die in Abhängigkeit von dem jeweils verwendeten Aufdampfmaterial etwa $1500^\circ$ bis $2000^\circ$ C betragen können. Diese Betriebstemperaturen müssen in möglichst kurzer Zeit erreicht werden, um sicherzustellen, daß die zu beschichtenden Formteile, insbesondere wenn diese beispielsweise aus Kunststoff bestehen, nicht durch Wärmestrahlung beschädigt werden, bevor sie durch die reflektierende Beschichtung dagegen geschützt sind. Kurze Aufdampfzeiten im Bereich von beispielsweise etwa 20 Sekunden sind dabei vorteilhaft. Nach beendetem Aufdampfvorgang müssen die beschichteten Formteile ebenfalls möglichst rasch abgekühlt werden, was üblicherweise durch Belüften des Vakuumbehälters erfolgt, damit die unbedampften Flächen der Formteile, beispielsweise deren Rückseiten, nicht durch Konvektionswärme überhitzt werden, was ebenfalls zu Beschädigungen führen kann.

Als Verdampferquellen, die den Anforderungen hinsichtlich kurzer Aufheizzeit genügen, kommen daher praktisch nur refraktäre Metalle in Betracht, wie strombeheizte Wolframwendeln und Schiffchen aus Wolfram-, Molybdän- oder Tantalblech.

Obwohl mit derartigen Verdampfern ausgezeichnete Ergebnisse erzielt werden, stellt jedoch deren kurze Lebensdauer einen entscheidenden Nachteil dar. So können beispielsweise Wolframwendeln nur etwa für 10 bis 20 Bedampfungsvorgänge, Schiffchen aus Tantalblech hingegen bis zu etwa 50 Bedampfungsvorgängen verwendet werden.

Die bekannten Verdampferschiffchen aus Sinterkeramik, beispielsweise aus Bornitrid und/oder Aluminiumnitrid und Titandiborid, weisen hingegen eine beträchtlich längere Lebensdauer auf. Diese können beispielsweise in kontinuierlich betriebenen Bandbedampfungsanlagen für die Beschichtung von Bandmaterialien, wie Kunststoffolien, Papierbahnen oder Textilien mit Aluminium bis zu einer Betriebsdauer von etwa 15 Stunden eingesetzt werden. Beim diskontinuierlichen Verfahren genügen sie indessen nicht den Anforderungen hinsichtlich der kurzen Aufheizzeit, die beim kontinuierlichen Verfahren praktisch von untergeordneter Bedeutung ist. Außerdem müssen sie relativ langsam abgekühlt werden, da sie bei Luftzufuhr in heißem Zustand zur Verzunderung neigen, d.h. oxidativ zerstört werden können, was auch bei den bisher üblichen, kontinuierlich betriebenen Bandbedampfungsanlagen als Nachteil empfunden wird.

Es stellt sich somit die Aufgabe, eine Vorrichtung zur Verfügung zu stellen, durch welche Verdampferschiffchen aus Sinterkeramik wirksam gegen die mögliche oxidative Zerstörung bei Luftzufuhr in noch heißem Zustand geschützt werden und die es insbesondere ermöglicht, derartige Verdampferschiffchen mit langer Lebensdauer auch in diskontinuierlich betriebenen HV-Aufdampfanlagen zu verwenden, ohne daß durch die hierbei erforderlichen langen Aufheiz- und Abkühlungszeiten die zu bedampfenden bzw. bereits bedampften Formteile oder Gegenstände Beschädigungen durch Wärmestrahlung bzw. Konvektionswärme ausgesetzt werden.

Bei der Vorrichtung zum diskontinuierlichen oder kontinuierlichen thermischen Bedampfen von beweglich oder unbeweglich angeordneten Formteilen oder Bandmaterialien mit Aufdampfmaterialien in einem Vakuumbehälter mittels mindestens einem, aus refraktärem Material bestehendem Verdampfer wird diese Aufgabe erfindungsgemäß dadurch gelöst, daß innerhalb des ersten Vakuumbehälters, in dem sich die zu bedampfenden Formteile oder Bandmaterialien befinden, ein zweiter Behälter angeordnet ist, in dem der bzw. die Verdampfer montiert sind und der unabhängig vom ersten Behälter vakuumdicht verschließbar ist.

Bei der Durchführung des Verfahrens wird demnach vor Beginn und/oder nach Beendigung des Bedampfungsvorganges der zweite Behälter vakuumdicht verschlossen.

Dadurch sind beim diskontinuierlichen thermischen Bedampfen die zu beschichtenden Formteile während des Aufheizvorganges von dem oder den Verdampfern durch den zweiten Vakuumbehälter abgeschirmt und können nicht durch Hitzestrahlung vorzeitig beschädigt werden. Erst wenn der oder die Verdampfer die erforderliche Betriebstemperatur erreicht haben, wird der zweite oder innere Vakuumbehälter geöffnet und die Formteile der Bedampfung durch das Aufdampfmaterial ausgesetzt. Nach beendetem Aufdampfvorgang wird der zweite Vakuumbehälter erneut verschlossen und der Hauptbehälter rasch belüftet, um so die mögliche Beschädigung der beschichteten Formteile an den unbeschichteten Stellen (Rückseiten) durch Konvektionswärme auszuschließen. Die in heißem Zustand gegen die Luftzufuhr empfindlichen Verdampfer sind hingegen während des Abkühlens durch den zweiten Behälter abgeschlossen und somit der möglichen Verzunderung oder oxidativen Zerstörung durch die rasche Belüftung entzogen, was sich nicht nur in diskontinuierlich betriebenen Aufdampfanlagen, sondern auch in kontinuierlich betriebenen Bandbedampfungsanlagen bewährt hat.

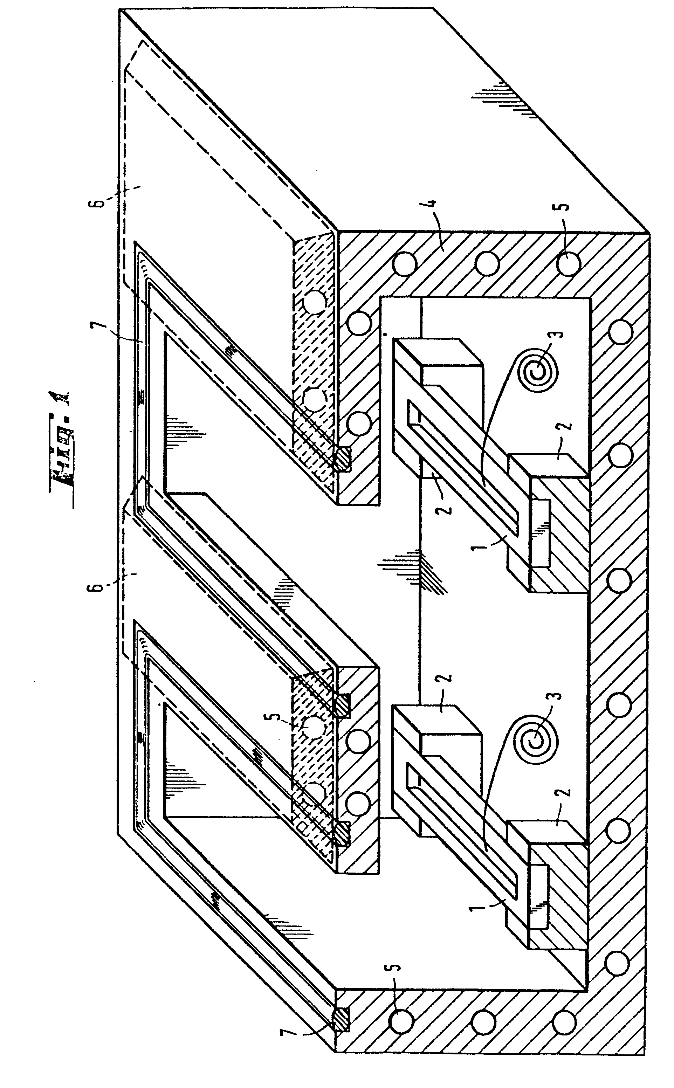

Die Anordnung und die Form des zweiten Vakuumbehälters in der erfindungsgemäßen Vorrichtung kann in weitem Bereich variiert werden, wobei sich folgende Ausführungsformen, die anhand der Abbildungen 1 bis 3 näher erläutert werden, besonders bewährt haben.

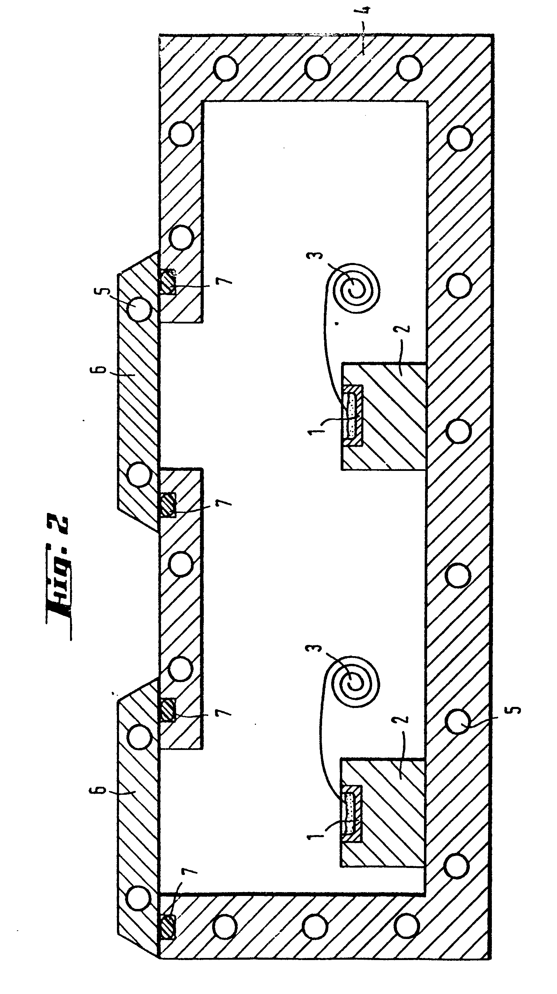

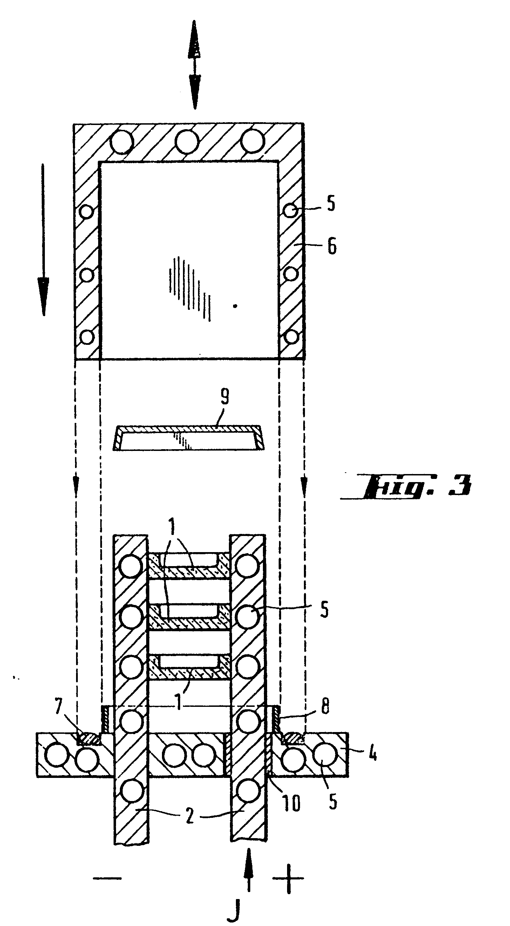

Die Abbildungen 1 und 2 zeigen einen inneren Vakuumbehälter mit horizontal angeordneten Verdampfern. Abbildung 3 zeigt eine weitere Ausführungsform des inneren Vakuumbehälters mit senkrecht übereinander angeordneten Verdampfern. In den Abbildungen sind jeweils gleiche Teile durch gleiche Bezugsziffern gekennzeichnet.

Abbildung 1 stellt die perspektivische Ansicht des Vakuumbehälters im geöffneten Zustand dar, Abbildung 2 hingegen die Ansicht desselben im Querschnitt und in geschlossenem Zustand. Wie aus diesen Abbildungen ersichtlich, sind die Verdampferschiffchen aus Sinterkeramik 1 in der Haltevorrichtung 2, die gleichzeitig als Stromzuführung dient, am Boden des Behälters 4 nebeneinander angeordnet. Neben den Verdampferschiffchen befindet sich das Aufdampfmaterial in Form der Aluminiumdrahtrolle 3. Der Behälter 4 kann beispielsweise aus rostfreiem Stahl bestehen. Für die Kühlung des Behälters 4 und des beweglichen Deckels 6 sind elastische Kühlwasserschlangen 5 vorgesehen. Der Deckel 6, der vorteilhaft mit abgeschrägten Kanten ausgebildet ist, kann durch übliche mechanische oder elektrische Vorrichtungen (nicht gezeigt) durch Verschieben bewegt werden. Die Bewegung des Deckels 6 kann jedoch auch durch Heben - Senken, Drehen oder Umklappen erfolgen. Durch den Dichtungsring 7 wird der vakuumdichte Verschluß des Deckels 6 garantiert.

In Abbildung 3 ist der Vakuumbehälter im Querschnitt und in geöffnetem Zustand dargestellt. Wie hieraus ersichtlich, ist der Behälter 4 als Grundplatte ausgebildet, durch welche die Elektroden, die gleichzeitig als Haltevorrichtung 2 für die Verdampferschiffchen 1 dienen, vakuumdicht und elektrisch isoliert geführt werden. Das Aufdampfmaterial, das bei dieser Ansicht im Querschnitt nicht sichtbar ist, kann beispielsweise in Form einer Abspulvorrichtung für Draht oder Band oder einer automatischen Nachfüllvorrichtung, wie einer Pulverstreuvorrichtung, angeordnet sein. Die elastischen Kühlwasserschlangen 5 dienen zur Kühlung der Grundplatte 4, der Elektroden 2 und des beweglichen Deckels 6. Zum vakuumdichten Verschließen des Behälters wird der haubenförmig ausgebildete Deckel 6 durch Bewegen in Pfeilrichtung auf die Grundplatte 4 aufgesetzt, wobei die Deckelführung 8 zum Justieren der Haube 6 dient und der Dichtungsring 7 den vakuumdichten Verschluß derselben garantiert. Zwischen dem haubenförmigen Deckel 6 und der Grundplatte 4 mit den Elektroden 2 und den Verdampfern 1 ist die unbewegliche Schale 9 angeordnet, die beispielsweise durch eine starre Vorrichtung an den Elektroden befestigt sein kann (nicht gezeigt). Diese dient zum Schutz des Deckels 6 gegen das Bedampfen, wenn dieser während des Bedampfungsvorganges hochgezogen ist. Die Elektroden 2 sind an der Führung durch die Grundplatte 4 an beiden Seiten durch die Isolierung 10 geschützt (aus Gründen der Übersichtlichkeit wurde die Isolierung 10 in Abbildung 3 nur für eine Elektrode eingezeichnet).

Durch die erfindungsgemäße Vorrichtung, die den Einsatz von Verdampferschiffchen aus Sinterkeramik mit langer Lebensdauer ermöglicht, werden beim diskontinuierlichen thermischen Bedampfen in HV-Aufdampfanlagen sehr kurze Arbeitszyklen erreicht, da letztere nicht mehr durch häufiges Auswechseln von kurzlebigen Verdampfern beeinträchtigt werden. Darüberhinaus können die übrigen bekannten vorteilhaften Eigenschaften der Verdampfer aus Sinterkeramik, beispielsweise deren große flache Verdampferoberflächen, die das Erzeugen von äußerst dichten Dampfstrahlen begünstigen, was bekanntlich für die hervorragende Qualität der gebildeten Beschichtungen von entscheidender Bedeutung ist, nunmehr auch beim diskontinuierlichen thermischen Bedampfungsverfahren voll ausgenützt werden.

Auch bei kontinuierlich betriebenen Bandbedampfungsanlagen ist es mit Hilfe der erfindungsgemäßen Vorrichtung möglich, die Verdampfer in der zweiten Kammer unter vermindertem Druck auf-

0008807

zuheizen, während die Rollen für das zu beschichtende oder bereits beschichtete Bandmaterial ausgewechselt werden oder die Evakuierung der ersten oder Hauptkammer vorgenommen wird. Desgleichen können die Verdampfer unter vermindertem Druck abgekühlt werden, während die Hauptkammer bereits belüftet wird. Darüberhinaus kann auch bei unbeabsichtigtem Druckaufbau in der Hauptkammer die zweite Kammer unmittelbar verschlossen werden, wobei es vorteilhaft ist, die zweite Kammer mit einer selbständig arbeitenden Vakuumpumpe zu verbinden, um eine Beschädigung der Verdampfer durch den Zusammenbruch des Vakuums in der Hauptkammer zu vermeiden.

0008807

Patentansprüche

1. Vorrichtung zum diskontinuierlichen oder kontinuierlichen thermischen Bedampfen von beweglich oder unbeweglich angeordneten Formteilen oder Bandmaterial mit Aufdampfmaterialien in einem Vakuumbehälter mittels mindestens einem, aus refraktärem Material bestehenden Verdampfer, d a - d u r c h  g e k e n n z e i c h n e t , daß innerhalb des ersten Vakuumbehälters, in dem sich die zu bedampfenden Formteile oder das Bandmaterial befinden, ein zweiter Behälter angeordnet ist, in dem der bzw. die Verdampfer montiert sind und der unabhängig vom ersten Behälter vakuumdicht verschließbar ist.

2. Verfahren zum diskontinuierlichen oder kontinuierlichen thermischen Bedampfen unter Verwendung der Vorrichtung gemäß Anspruch 1, d a d u r c h  g e k e n n z e i c h n e t , daß vor Beginn und/oder nach Beendigung des Bedampfungsvorganges der zweite Behälter vakuumdicht geschlossen wird.

FIG. 1

Fig. 2

*Fig. 3*

0008807

Europäisches
Patentamt

**EUROPÄISCHER RECHERCHENBERICHT**

Nummer der Anmeldung
EP 79 10 3388

| EINSCHLÄGIGE DOKUMENTE | | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | C 23 C 13/08 |
| X | <u>DE - C - 961 772</u> (H. WALTER)<br><br>* Ansprüche 1,2; Seite 1; Seite 2; Figur 1 *<br><br>-- | 1 | |
| X | <u>FR - A - 1 572 214</u> (R.T.C.)<br><br>* Zusammenfassung; Figuren 1,2; Seite 3, rechte Spalte, Absätze 3-5 *<br><br>-- | 1 | |
| | <u>FR - A - 2 299 907</u> (APPLIED MATE-RIALS)<br><br>* Ansprüche 1,4,5,7; Figur 2 *<br><br>-- | 1,2 | RECHERCHIERTE SACHGEBIETE (Int. Cl. 3)<br><br>C 23 C 13/08<br>13/12 |
| | <u>DE - A - 1 521 532</u> (TELEFUNKEN)<br><br>* Ansprüche 1,3,5; Figuren 1-3 *<br><br>-- | 1 | |
| | <u>DE - A - 2 330 710</u> (LEYBOLD HERA-EUS)<br><br>* Anspruch 1; Figur 1 *<br><br>-- | 1 | |
| | <u>US - A - 3 649 339</u> (E.C. SMITH)<br><br>* Ansprüche 1,5,8; Figur 1 *<br><br>-- | 1 | KATEGORIE DER GENANNTEN DOKUMENTE<br><br>X: von besonderer Bedeutung<br>A: technologischer Hintergrund<br>O: nichtschriftliche Offenbarung<br>P: Zwischenliteratur<br>T: der Erfindung zugrunde liegende Theorien oder Grundsätze<br>E: kollidierende Anmeldung<br>D: in der Anmeldung angeführtes Dokument<br>L: aus andern Gründen angeführtes Dokument |
| | <u>US - A - 3 641 973</u> (R.L. SHRADER)<br><br>* Ansprüche 1,6; Figuren 1,2 *<br><br>-- | 1 | |
| | <u>US - A - 3 568 632</u> (G.F. CAWTHON)<br><br>* Ansprüche 1,7,8; Figuren 1,2 *<br><br>-- ./. | 1 | &: Mitglied der gleichen Patentfamilie, übereinstimmendes Dokument |

Der vorliegende Recherchenbericht wurde für alle Patentansprüche erstellt

| Recherchenort | Abschlußdatum der Recherche | Prüfer |
|---|---|---|
| Den Haag | 17-12-1979 | DEVISME |

EPA form 1503.1  06.78

**Europäisches Patentamt**

**EUROPÄISCHER RECHERCHENBERICHT**

| EINSCHLÄGIGE DOKUMENTE | | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | |
| | FR - A - 2 262 126 (I.B.M.) <br> * Ansprüche 1,4-8; Figur 1; Seite 5, Zeilen 38-40; Seite 6, Zeilen 1-25 * <br><br> -- <br><br> FR - A - 2 002 902 (LIBBEY-OWENS) <br> * Anspruch 1 * <br><br> ---- | 1 | |
| | | | RECHERCHIERTE SACHGEBIETE (Int. Cl. 3) |

EPA Form 1503.2 06.78